# DEMANDE DE BREVET EUROPEEN

(11) **EP 2 434 070 A1**
(43) Date de publication de la demande: **28.03.2012**
(21) Numéro de dépôt: 11183121.0
(22) Date de dépôt: 28.09.2011
(51) Int. Cl.: E04F 10/06, E06B 9/42, H01L 31/045

(54) **Dispositif de protection solaire de type store muni d'un système de production d'énergie électrique**

(30) Priorité: 28.09.2010 FR 1057805
(71) Demandeur: Dickson Constant, 59290 Wasquehal (FR)
(72) Inventeur: Nocito, Christophe, 59100 Roubaix (FR); Raymond, Laurent, 59134 Fournes-en-Weppes (FR); Boussu, François, 59190 Caestre (FR)
(74) Mandataire: Balesta, Pierre

(57) **Abrégé**

L'invention concerne un dispositif de protection solaire du type store (1) muni d'un système de production d'énergie électrique, le dispositif comprenant un panneau souple (2), au moins un panneau photovoltaïque (4) disposé sur la face externe (2d) du panneau souple, un tube enrouleur (3) sur lequel s'enroule le panneau souple et un système de mise en tension du panneau souple durant son déploiement ou son enroulement. Selon l'invention, le bord proximal (2a) du panneau souple (2) est assujetti au tube enrouleur (3) en formant autour dudit tube enrouleur une portion non déroulable. En outre, des moyens de liaison électriques (18, 19) sont disposés à l'intérieur (8) du tube enrouleur et traversent ledit tube enrouleur dans la portion non déroulable du panneau souple, lesdits moyens de liaison électriques étant raccordés à l'au moins un panneau photovoltaïque (4) au niveau du bord proximal (2a) du panneau souple (2).

## Description

La présente invention concerne un dispositif de protection solaire de type store muni d'un système de production d'énergie électrique. L'énergie électrique produite peut par exemple être emmagasinée dans un accumulateur de type batterie ou être restituée à un appareil tel que par exemple un brumisateur, un système chauffant, un système d'éclairage ou autre.

Les dispositifs de protection solaire de type store comprennent de manière habituelle un tube enrouleur qui est par exemple actionné au moyen d'un mécanisme de type manivelle entraînant la rotation dans un sens ou dans l'autre du tube enrouleur. Une telle manivelle peut toutefois être remplacée par un système motorisé.

Le store comprend également un panneau souple susceptible d'être enroulé sur le tube enrouleur lorsque ce dernier tourne dans un sens et, inversement, d'être déroulé dudit tube enrouleur lorsque celui-ci tourne dans le sens opposé. Le store comprend en outre un système de mise en tension qui exerce une traction sur l'extrémité distale du panneau souple. Ainsi, lorsque le tube enrouleur tourne dans le sens d'enroulement, la tension exercée sur l'extrémité du panneau permet d'enrouler celui-ci en le maintenant convenablement tendu, le système de mise en tension se rétractant au fur et à mesure, ce qui garantit un repliement ou un enroulement convenable du panneau souple autour du tube enrouleur, Au contraire, lorsque le panneau souple se déroule du tube enrouleur, le système de mise en tension se déploie et assure le déploiement du panneau souple en le maintenant tendu.

Durant l'utilisation du store, le panneau souple est déployé, celui-ci permettant de filtrer les rayons solaires. Dans la position déployée, la face externe du panneau souple est exposée aux rayons solaires. L'homme du métier a déjà envisagé l'exploitation de cette conception de store en intégrant sur la face externe du panneau souple un ou plusieurs panneaux photovoltaïques qui captent les rayons du soleil afin de produire de l'énergie électrique, laquelle peut être stockée au moyen d'une batterie voire peut alimenter directement un appareil électrique approprié tel qu'un brumisateur ou une source d'éclairage.

Une telle conception est par exemple décrite dans la publication EP.1.082.062 131.

Selon cette conception de dispositif de protection solaire du type store, le système de mise sous tension comprend une barre de charge disposée à l'extrémité distale du panneau souple et un ou plusieurs bras articulés montés sur ressorts ou vérins. Ce bras articulé tend à revenir vers une position normale déployée sous l'effet du ressort, en l'absence d'un effort de retenue exercé par la portion du panneau souple enroulée sur le tube enrouleur.

Ces bras articulés du système de mise sous tension présentent des conduits ou des réservations permettant le passage des câbles d'alimentation électriques raccordés d'un côté aux électrodes des panneaux photovoltaïques disposées au niveau de l'extrémité distale du panneau souple, à proximité de la barre de charge et, de l'autre, à une batterie d'accumulation de l'énergie ou à un appareil électrique. Ces conduits ou réservations ont pour inconvénient d'augmenter la section des bras articulés. Par ailleurs, les câbles d'alimentation électrique sont disposés dans ces bras articulés, ce qui, à chaque actionnement du store, plie les câbles d'alimentation. Il en résulte une usure par fatigue de ces câbles pouvant à terme être endommagés.

L'invention vise à pallier ces inconvénients. A cet effet, l'invention concerne un dispositif de protection solaire de type store muni d'un système de production d'énergie électrique. Ce dispositif comprend un panneau souple et au moins un panneau photovoltaïque également souple et disposé sur la face externe du panneau souple. De même, le dispositif de protection solaire de type store comprend un tube enrouleur sur lequel s'enroule le panneau souple voire se déroule de celui-ci selon le sens d'actionnement du tube enrouleur. Pour cela le store comprend également un système d'actionnement en rotation du tube enrouleur pouvant être mécanique voire motorisé, de tels systèmes d'actionnement étant connus de l'homme du métier. On comprend que l'au moins un panneau photovoltaïques, fixé sur la face externe du panneau souple, s'enroule concomitamment au panneau souple autour du tube enrouleur voire se déroule de celui-ci selon son sens de rotation.

Le dispositif de protection solaire de type store comprend également un système de mise en tension du panneau souple durant son déploiement ou son enroulement. Un tel système de mise en tension sera de préférence constitué d'une barre de charge fixée à l'extrémité distale du panneau souple et d'au moins un bras articulé, tel que cela est connu de l'homme du métier. On pourrait bien entendu envisager des variantes du système de mise sous tension du panneau souple sans sortir du cadre de l'invention.

De manière remarquable et selon le dispositif de protection solaire de type store objet de l'invention, le bord proximal du panneau souple est assujetti au tube enrouleur en formant autour dudit tube enrouleur une portion non déroulable vis-à-vis de ce tube. Par ailleurs, des moyens de liaison électrique sont disposés à l'intérieur du tube enrouleur et traversent ledit tube enrouleur dans la portion non déroulable du panneau souple. En outre, les moyens de liaison électrique sont raccordés d'une part audit au moins un panneau photovoltaïque, au niveau du bord proximal du panneau souple.

D'autre part, ces moyens de liaison électrique demeurent à l'intérieur du tube enrouleur en vue de l'alimentation d'un appareil électrique. Ces moyens de liaison électriques sont donc immobiles vis-à-vis du tube enrouleur avec lequel ils tournent.

Ainsi, la conception du dispositif de protection solaire de type store objet de la présente invention tel que décrite ci-dessus présente pour avantage de supprimer le passage externe des câbles de liaison électriques entre les panneaux photovoltaïques et l'appareil électrique de type batterie ou autre, en passant par les bras articulés du système de mise en tension tel que cela est connu selon l'art antérieur. Cela permet donc de réduire la section des bras articulés. La conception objet de la présente invention décrite ci-dessus présente en outre pour avantage de pouvoir être mise en oeuvre avec d'autres systèmes de mise sous tension tels que par exemple des câbles de tension montés en rappel par ressort sur des enrouleurs et assujettis à l'extrémité distale du panneau souple de sorte d'exercer une traction sur celle-ci et ainsi, tendre le panneau souple.

La conception du dispositif de protection solaire de type store, décrite ci-dessus, présente en outre pour avantage d'éviter tout déplacement relatif entre les moyens de liaison électrique et le tube enrouleur lors de l'actionnement de celui-ci. Le raccordement des moyens de liaison électrique avec au moins un panneau photovoltaïque au niveau du bord proximal du panneau souple non déroulable du tube enrouleur, évite également tout effort sur les connexions entre les moyens de liaison électrique et l'au moins un panneau photovoltaïques, ce qui évite tout risque de rupture de la connexion électrique entre lesdits éléments.

Selon l'objet de l'invention, on pourrait envisager la mise en place d'un appareil de type batterie ou autre à l'intérieur du tube enrouleur, dans quel cas les moyens de liaison électrique seraient raccordés directement à cet appareil électrique disposés à l'intérieur du tube enrouleur. Toutefois, selon l'invention, le dispositif de protection solaire est de préférence raccordé à un appareil électrique externe. Pour cela, le dispositif de protection solaire de type store objet de la présente invention comprend un système de transfert électrique, comprenant une partie mobile assujettie à l'une des extrémités du tube enrouleur et tournant avec celui-ci et une partie fixe permettant la connexion ou le raccordement électrique d'un appareil électrique externe tel que par exemple une batterie en vue de l'accumulation de l'énergie électrique voire un brumisateur, un système d'éclairage, un système chauffant ou autre. Ce système de transfert électrique comprend également des moyens de contact glissants configurés pour assurer une continuité électrique entre la partie mobile et la partie fixe et ainsi, transférer l'énergie électrique de la partie mobile vers la partie fixe.

De préférence, selon cette conception du dispositif de protection solaire de type store objet de la présente invention, la partie mobile du système de transfert électrique comprend deux pistes conductrices concentriques de diamètres différents et la partie fixe du système de transfert électrique comprend au moins deux contacteurs électriques configurés pour être maintenus respectivement en appui contre les deux pistes conductrices concentriques. De préférence, la partie fixe comprend au moins quatre contacteurs électriques afin d'améliorer la stabilité de la liaison en rotation de la partie fixe avec la partie mobile.

On pourrait toutefois envisager une inversion, c'est-à-dire la mise en oeuvre des pistes conductrices concentriques sur la partie fixe et des contacteurs électriques sur la partie mobile, sans sortir du cadre de l'invention.

Selon cette conception préférentielle de l'invention, les contacteurs électriques comprennent chacun des premiers moyens de raccordement électrique, lesquels ont pour but de permettre le raccordement d'un appareil électrique externe. De même, selon l'invention, les pistes conductrices concentriques comprennent chacune des seconds moyens de raccordement au moyen de liaisons électriques disposées à l'intérieur du tube enrouleur.

Selon cette conception préférentielle, l'au moins un panneau photovoltaïque comprend au niveau de son bord proximal une électrode positive et une électrode négative, lesdites électrodes positive et négative étant raccordées respectivement aux deux pistes conductrices concentriques par le biais des moyens de liaison électrique. Bien entendu, dans le cas où le dispositif de protection solaire comprend plus d'un panneau photovoltaïque, chacun d'eux dispose d'une électrode positive et d'une électrode négative, les moyens de liaison électrique permettant respectivement le raccordement de toutes les électrodes négatives à l'une des deux pistes conductrices concentriques et le raccordement de toutes les électrodes positives à l'autre des deux pistes conductrices concentriques.

De préférence, les moyens de liaison électrique sont constitués d'au moins un jeu de deux fils électriques raccordés à leur première extrémité respectivement aux électrodes positive et négative dudit au moins un panneau photovoltaïque et à leur seconde extrémité respectivement aux deux pistes conductrices concentriques. Le dispositif de protection solaire comprendra autant de jeux de deux fils électriques que de panneaux photovoltaïques.

De préférence, ces fils électriques ont leurs premières extrémités dénudées qui passent au travers du tube enrouleur et sont respectivement soudées aux électrodes du panneau photovoltaïque, au niveau de la portion proximale du panneau souple non déroulable vis-à-vis du tube enrouleur.

Selon une conception préférentielle de l'invention, les contacteurs électriques sont montés sur ressorts en sorte d'assurer une pression permanente sur les pistes conductrices concentriques.

Selon l'invention, une liaison de type queue d'aronde est agencée entre l'extrémité proximale du panneau souple et le tube enrouleur. On peut bien entendu envisager des liaisons s'apparentant à celles d'une queue d'aronde sans sortir du cadre de la présente invention. Cette liaison a pour but de garantir une fixation permanente du panneau souple avec le tube enrouleur en cas d'une éventuelle rupture des moyens d'assemblage du panneau souple avec ledit tube enrouleur, dans la portion proximale non déroulable.

Dans une variante, le dispositif selon l'invention comprend un moteur d'entraînement du tube enrouleur et la partie mobile du système de transfert électrique comprend une ouverture centrale configurée en sorte de recevoir l'extrémité proximale mobile dudit moteur.

L'extrémité proximale mobile du moteur entraîne en rotation la partie mobile du système de transfert électrique ainsi que le tube enrouleur et éventuellement le tambour.

Ledit moteur est délimité entre des extrémités proximale et distale, au moins l'une de ses extrémités est raccordée à une première extrémité du tube enrouleur et du tambour, de préférence les secondes extrémités du tube enrouleur et du tambour ne sont pas en liaison avec l'extrémité distale dudit moteur. Dans ce dernier cas, la longueur dudit moteur est bien inférieure à la longueur du tube enrouleur et à celle du tambour.

De préférence, la partie mobile comprend, sur une première face orientée vers le tube enrouleur, au moins deux rainures radiales se projetant de la périphérie de son ouverture centrale pour ménager au moins deux espaces dans lesquels les seconds moyens de raccordement électrique du ou des panneaux photovoltaïques peuvent s'engager et ainsi sont raccordés électriquement respectivement aux deux pistes électriquement conductrices et concentriques, lesquelles pistes sont supportées sur une seconde face de la partie mobile opposée à ladite première face.

Dans une variante, la partie fixe du système de transfert électrique comprend au moins une ouverture de sortie des moyens de raccordement électrique du moteur d'entraînement du tube enrouleur, et éventuellement un évidement central configuré en sorte de recevoir l'extrémité proximale fixe dudit moteur.

Dans une sous-variante, ledit évidement central est traversant et se présente alors sous la forme d'une ouverture centrale.

Avantageusement, les moyens de raccordement électrique du moteur d'entrainement sortent de la partie fixe par la même extrémité du coffre recevant le tube enrouleur que les premiers moyens de raccordement électriques des contacteurs, ou éventuellement des pistes conductrices, ce qui permet de réduire la longueur et donc l'encombrement des moyens de liaison électrique des panneaux photovoltaïques, lesquels peuvent ainsi sortir par la même extrémité du tube enrouleur, et donc du coffre, que les moyens de raccordement électrique du moteur d'entraînement. Cette disposition permet ainsi de limiter les pertes d'énergie électrique produite par le ou les panneaux photovoltaïques.

Eventuellement lesdits moyens de raccordement électrique et lesdits moyens de liaison électrique peuvent être regroupés en un même faisceau de câble.

L'optimisation de la longueur des moyens de liaison électrique du ou des panneaux photovoltaïque permet de limiter les pertes lors du transport de l'énergie électrique produite par lesdits panneaux photovoltaïques.

Par ailleurs, la réduction de l'encombrement des moyens de liaison électrique du ou des panneaux photovoltaïques permet d'aménager le dispositif selon l'invention dans des emplacements de taille réduite, tel que par exemple sur un camping-car ou un bateau.

Selon un mode de conception préférentiel, le tube enrouleur est actionné au moyen d'un moteur d'entraînement en rotation. En outre, un système de commande du moteur est configuré pour arrêter le moteur et, par conséquent, le tube enrouleur, lorsque celui-ci tourne dans un sens correspondant au déploiement du panneau souple et dans une position selon laquelle une partie du bord proximal du panneau souple demeure enroulée en permanence autour du tube enrouleur.

Dans une variante, ladite portion non déroulable du panneau souple s'étend sur au moins un quart de tour du tube enrouleur, de préférence sur au moins tout le tour du tube enrouleur en sorte de recouvrir le bord proximal du panneau souple assujetti au tube enrouleur et lesdits moyens de liaison électriques raccordés audit au moins un panneau photovoltaïque au niveau dudit bord proximal du panneau souple.

Si la portion non déroulable s'étend sur au moins un quart, l'encombrement du dispositif selon l'invention est réduit par rapport un dispositif dans lequel la portion non déroulable s'étend sur plus de un quart de tour. Il est alors nécessaire de solidariser ladite portion non déroulable sur un quart de tour du tube enrouleur à l'aide de moyens de fixation, par exemple de colle. Cette disposition peut être avantageuse concernant notamment la recherche d'un dispositif présentant un encombrement réduit pour équiper notamment des camping-cars ou des bateaux.

Si la portion non déroulable s'étend sur au moins un tour et recouvre le bord proximal assujetti au tube enrouleur, il n'est alors pas nécessaire de solidariser via des moyens de fixation, notamment du type colle, ladite portion non déroulable au tube enrouleur, puisque le panneau souple se bloque sur lui-même autour du tube enrouleur lorsqu'une traction est exercée sur son extrémité libre, s'agissant notamment d'une traction exercée par le système de mise en tension dudit panneau souple lors de son déploiement. Avantageusement, la portion non déroulable recouvre les moyens de liaison électriques traversant le tube enrouleur et en liaison électrique avec les électrodes positives et négatives du ou des panneaux photovoltaïques. Cette disposition permet ainsi d'améliorer encore la protection desdits moyens de liaison électriques et facilite l'aménagement d'une portion non déroulable du panneau souple autour du tube enrouleur.

Selon une variante de conception, le bord proximal du panneau souple est fixé avec le tube enrouleur dans la portion non déroulable, cette fixation étant par exemple réalisée par collage. On peut bien entendu envisager tout autre moyen de fixation de la portion proximale du panneau souple avec le tube enrouleur dans cette portion non déroulable.

De préférence, la portion non déroulable du panneau souple s'étend sur au moins un quart de tour du tube enrouleur.

De préférence, le panneau souple est recouvert de deux à quatre panneaux photovoltaïques selon les dimensions du dispositif de protection solaire de type store.

Les caractéristiques et avantages de l'invention apparaîtront à la lecture de la description suivante d'un mode préférentiel de conception qui s'appuie sur des figures parmi lesquelles :
- La figure 1 illustre une vue de face d'un tube enrouleur du dispositif de protection solaire de type store objet de l'invention;
- La figure 2 est une vue de côté de la figure 1 ;
- La figure 3A est une vue en coupe selon le plan A de la figure 2 mettant en évidence un mode de réalisation du système de transfert électrique ;
- La figure 3B est une vue en coupe selon le plan A de la figure 2 mettant en évidence l'extrémité proximale du moteur d'entraînement ;
- La figure 4 illustre le raccordement des panneaux photovoltaïques avec le tube enrouleur du dispositif de protection solaire de type store objet de la présente invention ;
- La figure 5 est un agrandissement de la figure 4 mettant en évidence l'assemblage du panneau souple avec le tube enrouleur ;
- Les figures 6 et 7 montrent suivant deux vues en perspective un mode préférentiel de conception du système de transfert électrique sur le dispositif de protection solaire de type store objet de l'invention, permettant de restituer l'énergie à un appareil électrique externe.
- La figure 8 représente une variante de l'agencement de la portion non déroulable du panneau photovoltaïque autour du tube enrouleur illustrée à la figure 4.

Le dispositif de protection solaire de type store 1 objet de la présente invention comprend, tel que cela est bien connu de l'homme du métier, un panneau souple 2, un tube enrouleur 3 et un système de mise en tension du panneau souple. Le panneau souple 2 comprend une largeur correspondant sensiblement à la longueur du tube enrouleur 3 sur lequel ledit panneau souple 2 peut être enroulé ou déroulé selon le sens de rotation du tube enrouleur 3. Le système de mise sous tension est de préférence constitué d'une barre de charge agencée à l'extrémité distale du panneau souple et d'un ou plusieurs bras articulés munis de systèmes de ressorts ou de vérins permettant de ramener dans une position normale les bras articulés en position déployée. Un tel système de mise sous tension est bien connu sur les stores existant sur le marché. Le panneau souple 2 comprend une longueur sensiblement égale à la longueur correspondante des bras articulés en position déployée. Lors de l'enroulement du panneau souple 2 autour du tube enrouleur 3, l'extrémité distale assujettie à la barre de charge exerce un effort sur les bras articulés qui se replient, la portion du panneau souple 2 non enroulé autour du tube enrouleur 3 restant convenablement tendue. Inversement, lorsque le panneau souple 2 est déroulé du tube enrouleur 3, les bras articulés tendent à revenir en position déployée ce qui assure le déploiement du panneau souple 2 en le maintenant convenablement tendu.

Le tube enrouleur 3 est actionné au moyen d'un système d'actionnement en rotation tel qu'une manivelle ou un système motorisé, également connu de l'homme du métier.

Le dispositif de protection solaire de type store 1 objet de la présente invention comprend également au moins un panneau photovoltaïque 4 qui est agencé sur la face externe du panneau souple 2. Par exemple le dispositif de protection solaire de type store 1 comprend entre deux et quatre panneaux photovoltaïque selon les dimensions de celui-ci. Ces panneaux photovoltaïques 4 sont souples, ce qui permet de les enrouler ou dérouler du tube enrouleur 3 concomitamment au panneau souple 2 sur lequel lesdits panneaux photovoltaïques sont fixés. Une telle conception de panneaux photovoltaïques souples est connue de l'homme du métier.

La fixation des panneaux photovoltaïque 4 sur la face externe du panneau souple 2 pourra être réalisée par tout moyen connu de l'homme du métier par exemple par collage, thermocollage ou soudage avec le panneau souple.

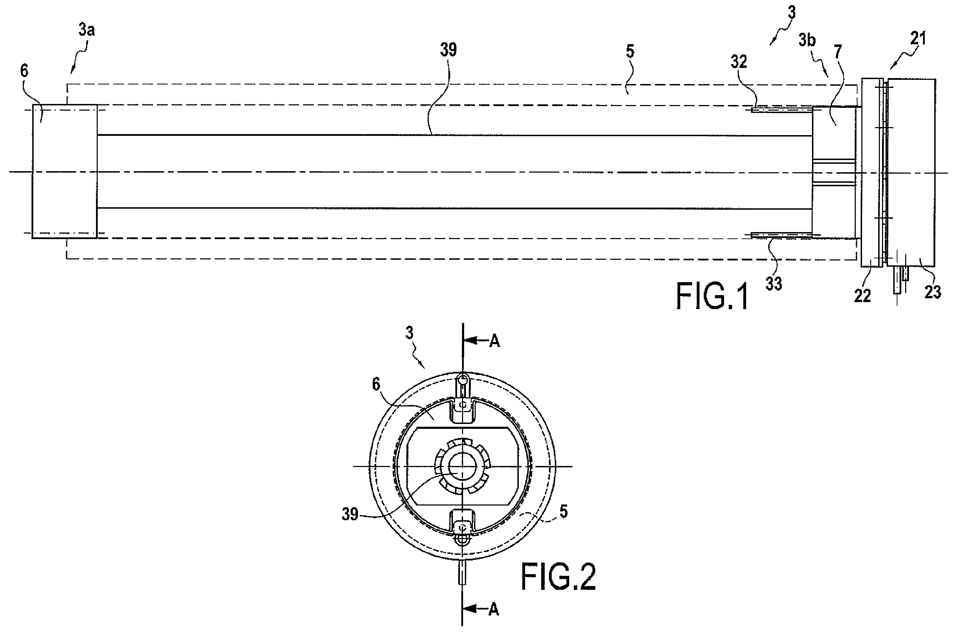

Les figures 1 à 3A-3B illustrent un exemple de conception du tube enrouleur 3 sur le dispositif de protection solaire de type store 1 objet de la présente invention.

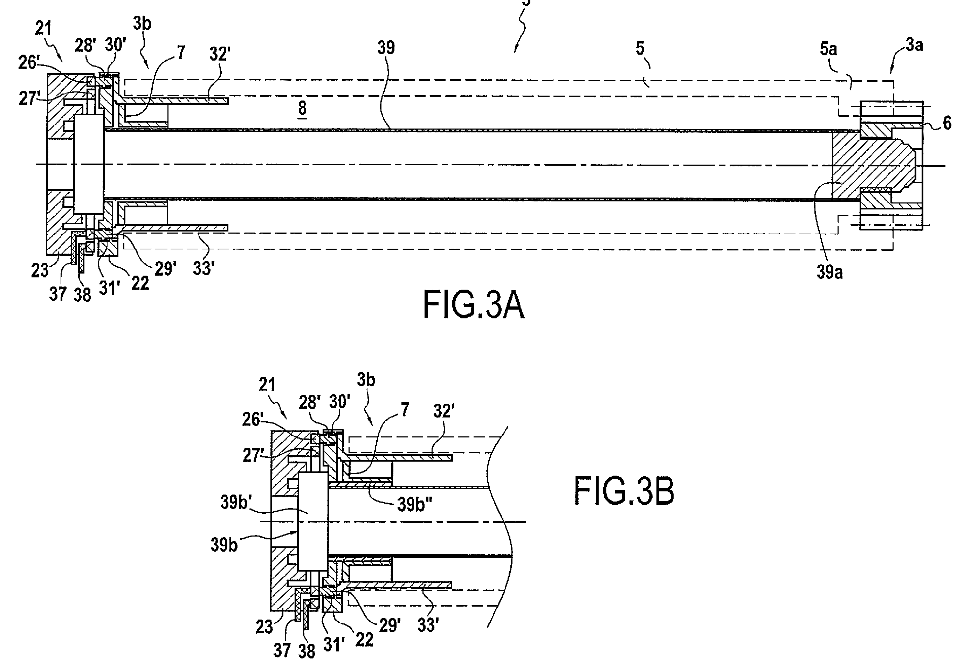

Le tube enrouleur 3 tel qu'illustré sur les figures 1 à 3A-3B, comprend un moteur 39 qui s'étend sur une partie de la longueur à l'intérieur dudit tube enrouleur 3 et, un tambour 5 illustré en pointillés sur les figures 1 à 3, autour duquel s'enroule le panneau souple 2. Le moteur 39 et le tambour 5 sont solidarisés entre eux en rotation au niveau d'au moins une des deux extrémités 3a, 3b au moyen de pièces d'assemblage 6, 7 illustrées en figures 3A et 3B. On constate sur la figure 3A que l'extrémité 5a du tambour 5, l'extrémité 39a du moteur 39 et la pièce d'assemblage 6 comprennent des cannelures permettant l'encastrement entre lesdits éléments en sorte de les lier en rotation. Ces pièces d'assemblage 6, 7 permettent en outre de maintenir coaxiaux le moteur 39 et le tambour 5. Ainsi, la mise en rotation du moteur 39 permet d'entraîner en rotation dans le même sens, le tambour 5.

On constate sur la figure 3A la présence entre le moteur 39 et le tambour 5 d'une chambre 8, c'est-à-dire un espace vide dans lequel peuvent être logés des éléments.

Le dispositif de protection solaire de type store 1, lorsqu'il est équipé d'un tel moteur 39 ou de tout système motorisé équivalent permettant d'entraîner en rotation le tube enrouleur 3, comprend un système de commande de moteur, non illustré sur les figures. Ce système de commande du moteur est configuré pour assurer l'arrêt du moteur 39 et par conséquent du tube enrouleur 3, lors du déploiement du panneau souple 2, dans une position selon laquelle on conserve en permanence une portion du bord proximal 2a du panneau souple 2 enroulée autour du tambour 5 du tube enrouleur 3. Ainsi, le bord proximal 2a du panneau souple 2 n'est pas déroulable du tambour 5 du tube enrouleur 3.

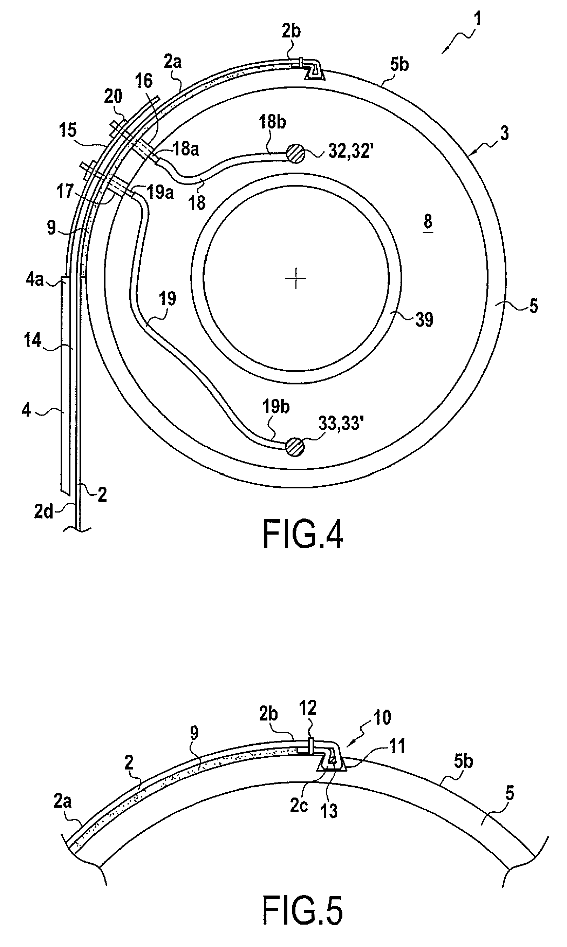

Le bord proximal 2a du panneau souple 2 peut éventuellement être assemblé vis-à-vis de la face externe 5b du tambour 5 sur un quart de tour dudit tambour 5, tel qu'illustré sur la figure 4, cet assemblage étant par exemple réalisé par collage 9. Ainsi, le bord proximal 2a du panneau souple 2 n'est pas déroulable du tube enrouleur 3.

L'extrémité proximale 2b du panneau souple 2 est assemblée vis-à-vis du tambour 5 au moyen d'une liaison de type queue d'aronde 10 illustrée plus en détail sur la figure 5. Pour cela, le tambour 5 comprend une rainure 11 en forme de queue d'aronde s'étendant longitudinalement sur ledit tambour 5. En outre, l'extrémité proximale 2b du panneau 2 est recourbée sur elle-même, la portion recourbée 2c étant disposée dans la rainure 11 en forme de queue d'aronde. On constate sur la figure 5 que la portion recourbée 2c comprend en outre un assemblage par couture 12 ou soudure. En outre, un lien de type jonc 13 s'étend longitudinalement à l'intérieur de la portion recourbée 2c, disposé dans la rainure 11 en queue d'aronde. Cette conception assure le maintien assemblé de l'extrémité proximale 2b du panneau souple 2 vis-à-vis du tambour 5. La forme de la rainure 11 peut être différente de celle d'une queue d'aronde. On pourrait en outre envisager d'autres moyens d'assemblage entre l'extrémité proximale 2b du panneau souple 2 et le tambour 5.

Sur la figure 4 on constate que le panneau photovoltaïque 4 est assemblée vis-à-vis de la face externe 2d du panneau souple 2. Cet assemblage peut être par exemple réalisé par collage, thermocollage ou soudage 14.

On constate sur la figure 4 la présence d'une électrode 15 agencée au niveau de l'extrémité proximale 4a du panneau photovoltaïque 4. Cette électrode 15 s'étend sur le bord proximal 2a du panneau souple 2, c'est-à-dire dans la portion du panneau souple non déroulable du tambour 5 du tube enrouleur 3. Bien entendu le panneau photovoltaïques 4 comprend deux électrodes 15 à savoir une électrode positive et une électrode négative. En outre, lorsque le dispositif de protection solaire de type store 1 comprend plusieurs panneaux photovoltaïques 4, chacun d'eux comprend une électrode positive et une électrode négative.

On constate sur la figure 4 que le tambour 5 comprend deux orifices 16, 17 permettant de traverser l'épaisseur dudit tambour 5 et d'accéder à la chambre 8. On constate sur cette figure 4 la présence de deux fils électriques 18, 19 ayant leurs premières extrémités 18a, 19a dénudées, ces fils électriques 18, 19 comprenant de préférence une gaine de protection isolante. Ces extrémités dénudés 18a, 19a des fils électriques 18, 19 passent au travers des orifices 16, 17 sur le tambour 5, ainsi qu'au travers du bord proximal 2a du panneau souple 2 comme on peut le constater sur la figure 4. On constate sur cette figure 4 que la première extrémité 18a du premier fil électrique 18 est assemblée vis-à-vis de l'électrode 15 constituant par exemple l'électrode positive. Cet assemblage est de préférence réalisé par soudage 20. Bien entendu, la seconde extrémité dénudée 19a du second fil électrique 19 est quant à elle assemblée de manière similaire avec la seconde électrode qui, dans ce cas, est l'électrode négative.

Dans le cas où le dispositif de protection solaire de type store 1 comprend plusieurs panneaux photovoltaïques 4, celui-ci comprendra autant de jeux de deux fils électriques 18, 19 raccordés respectivement à chacune des électrodes positives et des électrodes négatives, de manière similaire à celle décrite précédemment.

Les secondes extrémités 18b, 19b des fils électriques 18, 19 sont destinées à être raccordées directement ou indirectement sur un appareil électrique. Il serait possible, en effet, d'envisager de loger cet appareil électrique à l'intérieur de la chambre 8. Dans ce cas, cet appareil électrique serait configuré pour être logé à l'intérieur de cette chambre 8. Un tel appareil pourrait être par exemple des batteries permettant d'accumuler l'énergie électrique produite par les panneaux photovoltaïques 4.

Toutefois, tel qu'illustré sur les figures 1 à 3A-3B, 6 et 7, le dispositif de protection solaire de type store 1 objet de l'invention comprend de préférence un système de transfert électrique 21.

Ce système de transfert électrique 21 comprend une partie mobile 22 et une partie fixe 23. Tel qu'illustré sur les figures 1 et 3A-3B, la partie mobile 22 est fixée à l'extrémité 3b du tube enrouleur 3 et tourne avec celui-ci.

La partie fixe 23 est quant à elle destinée à être fixée vis-à-vis d'un châssis permettant notamment la fixation sur un support tel qu'un mur de bâtiment.

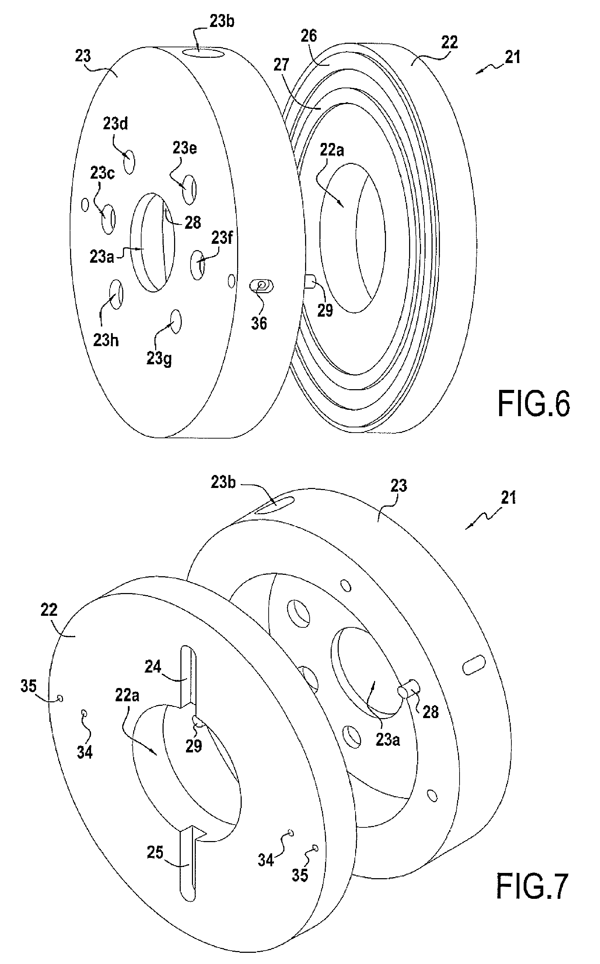

L'assemblage de la partie mobile 22 avec l'extrémité 3b du tube enrouleur 3 pourra être réalisé par tout moyen connu de l'homme du métier. Par exemple, on constate sur la figure 7, la présence de deux rainures radiales 24, 25 qui permettent la réception de pièces de la forme de clavettes, solidaires de l'extrémité 3b du tube enrouleur 3.

On constate au travers des figures 6 et 7 que la partie mobile 22 comprend deux pistes conductrices concentriques 26, 27. Ces deux pistes conductrices concentriques 26, 27 sont distantes l'une de l'autre et présentent pour cela des diamètres différents en sorte d'éviter tout contact entre celles-ci. En outre, la matière utilisée pour la partie mobile 22 est constituée d'un isolant électrique en sorte que seules les pistes conductrices concentriques 26, 27 puissent conduire l'électricité.

De même sur ces figures 6 et 7 on constate que la partie fixe 23 comprend deux contacteurs électriques 28, 29. Lorsque les parties fixe 23 et mobile 22 sont plaquées l'une contre l'autre tel qu'illustré sur la figure 1, les contacteurs électriques 28, 29 entrent respectivement en contact avec les deux pistes conductrices concentriques 26, 27, ce qui assure une continuité électrique entre la partie fixe 23 et la partie mobile 22 en mouvement l'une par rapport à l'autre. La partie fixe 23 est également réalisée dans un matériau isolant électrique, seuls les contacteurs électriques 28, 29 conduisant l'électricité.

Dans une variante, on remarque aux figures 6 et 7 que la partie mobile 22 comprend une ouverture centrale 22a configurée en sorte de recevoir l'extrémité proximale mobile 39b" dudit moteur 39. Dans une variante, la partie mobile 22 comprend des rainures radiales 24 et 25 se projetant radialement de son ouverture centrale 24 permettant l'accouplement par exemple avec les broches 32, 32', 33 et/ou 33', elles-mêmes en liaison électrique avec les moyens de liaison électrique (par exemple les fils électriques 18 et 19) disposés dans le tube enrouleur 3. Dans ce cas, les rainures 24 et 25 font parties des secondes moyens de raccordement électrique du ou des panneaux photovoltaïques. Les couples d'orifices 34,35 peuvent quant eux permettre la réception de pièces de la forme de clavettes, solidaires de l'extrémité 3b du tube enrouleur 3.

L'extrémité proximale mobile 39b" est représentée à la figure 3B et entraîne en rotation la partie mobile 22.

La partie fixe 23 comprend au moins une ouverture de sortie des moyens de raccordement électrique du moteur 39 d'entraînement du tube enrouleur 3.

Ladite ouverture de sortie peut être l'ouverture centrale 23a représentée aux figures 6 et 7, et/ou une ouverture latérale 23b.

De préférence, les ouvertures 23c à 23h disposées dans la partie fixe 23 sont destinées à recevoir des vis de fixation qui permettent de rendre solidaire ladite partie fixe 23 au coffre non représenté sur les figures.

Dans cette variante, l'ouverture centrale 23a de la partie fixe 23 est configurée en sorte de recevoir l'extrémité proximale fixe 39b' du moteur 39, ladite extrémité proximale fixe 39b' est représentée à la figure 3B.

Bien entendu, des variantes de réalisation du système de transfert électrique 21 peuvent être envisagées. On constate à ce titre sur la figure 3A une variante de conception par rapport à celles illustrées aux figures 6 et 7 selon laquelle deux pistes conductrices concentriques 26', 27' sont agencées sur la partie fixe 23 tandis que deux contacteurs électriques 28', 29' sont agencés sur la partie mobile 22. On constate sur cette figure 3A que les contacteurs électriques 28', 29' sont montés sur ressorts 30', 31' permettant de garantir un maintien en contact des contacteurs électriques 28', 29' respectivement sur les pistes conductrices concentriques 26', 27'. De tels ressorts sont également prévus sur le mode de conception illustré aux figures 6 et 7.

On constate sur la figure 1 la présence de deux broches 32, 33 réalisées dans un matériau conducteur électrique. Ces broches 32, 33 sont destinées à pénétrer à l'intérieur d'orifices 34, 35 illustrés en figure 7. Leurs positions correspondent respectivement aux positions des deux pistes conductrices concentriques 26, 27, lesdits orifices 34, 35 communiquant avec lesdites pistes conductrices concentriques 26, 27. Ces broches 32, 33 pénètrent dans les orifices 34, 35 et viennent en contact avec les pistes conductrices concentriques 26, 27 en sorte d'assurer une continuité de la liaison électrique.

Sur le mode de conception illustré en figure 3A, mais également à la figure 3B, on constate également la présence de broches 32 `, 33' dont la forme est configurée pour permettre une mise en contact avec les contacteurs électriques 28', 29'.

Selon ces deux variantes de conception du système de transfert électrique 21 illustré aux figures 6 et 7 et aux figures 3A et 3B, on constate que les broches 32, 33, 32', 33' sont disposées à l'intérieur de la chambre 8 à l'intérieur du tube enrouleur 3. Ces broches 32, 32', 33, 33' permettent respectivement le raccordement des extrémités 18b, 19b des deux fils électriques 18, 19 tels qu'illustrés sur la figure 4. En la présence de plusieurs panneaux photovoltaïques 4, chaque fil électrique 18 raccordé au niveau de son extrémité 18a à une électrode, par exemple l'électrode positive, d'une des panneaux photovoltaïques sera raccordé au niveau de son autre extrémité 18b à la première broche 32, 32'. De même, chaque fil électrique 19 raccordé au niveau de son extrémité à la seconde électrode, dans ce cas l'électrode négative, d'un des panneaux photovoltaïques 4, sera quant à lui raccordé au niveau de son autre extrémité 19b à la seconde broche 33, 33'. La connexion des extrémités 18b, 19b des deux fils électriques 18, 18a avec les broches 32, 32', 33, 33' peut être réalisée par tout moyen connu de l'homme du métier, par exemple par soudage.

On pourrait en outre prévoir le remplacement des fils électriques 18, 19 souples par d'autres moyens de liaison électrique tels qu'un prolongement des broches 32, 32', 33, 33', les prolongements étant raccordés aux électrodes des panneaux photovoltaïques en passant au travers du tube enrouleur 3.

On constate sur la figure 6 que le contacteur électrique 29 comprend des moyens de raccordement 36, lesquels sont également prévus sur le second contacteur électrique 28. Ces moyens de raccordement permettent de raccorder par exemple des câbles électriques qui seront raccordés ensuite à un appareil électrique externe tel qu'une batterie permettant l'accumulation de l'énergie électrique en vue de sa restitution ultérieure voire un appareil chauffant, un brumisateur, un système d'éclairage ou autre.

Sur la variante illustrée en figure 3A, on constate la présence de secondes broches 37, 38 constituant des sorties de câble, ces broches 37, 38 étant respectivement en contact avec les deux pistes conductrices concentriques 26', 27'.

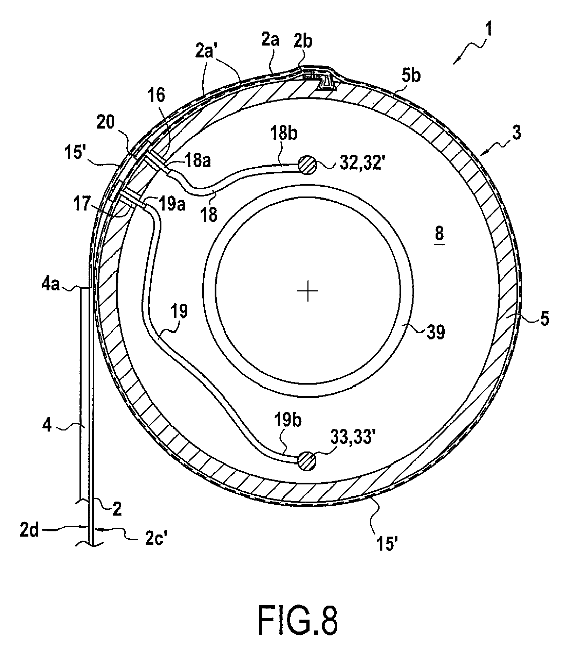

La figure 8 représente une variante de réalisation de la figure 4 sur laquelle le panneau souple 2 s'étend de son bord proximale 2a et sur au moins tout le tour du tube enrouleur 3 en sorte de recouvrir l'extrémité proximale 2b du panneau souple 2 assujetti au tube enrouleur 3 et ledit bord proximal 2a et former ainsi une portion non déroulable 2a'. Les références désignant les mêmes éléments qu'à la figure 4 sont reprises sur la figure 8.

Avantageusement dans cette variante, il n'est pas nécessaire de solidariser via des moyens de fixation, notamment du type colle, ladite portion non déroulable 2a' au tube enrouleur 3, puisque la portion non déroulable 2a' du panneau souple 2 se bloque sur elle-même autour du tube enrouleur 3 lorsqu'une traction est exercée sur le bord distale 2c' dudit panneau 2, s'agissant notamment d'une traction exercée par le système de mise en tension dudit panneau souple 2 lors de son déploiement. Avantageusement, la portion non déroulable 2a' recouvre les moyens de liaison électriques (20,18a,19a, 18,19) traversant le tube enrouleur 3 et en liaison électrique avec les électrodes positives et négatives 15 du ou des panneaux photovoltaïques 2. Cette disposition permet ainsi d'améliorer encore la protection desdits moyens de liaison électriques et facilite l'aménagement d'une portion non déroulable 2a' du panneau souple 2 autour du tube enrouleur 3. Les électrodes positives et négatives s'étendant du panneau photovoltaïque 4 sont matérialisées par les pointillés référencés 15'. Lesdites électrodes 15' sont de préférence des fils dans un matériau conducteur d'électricité, de préférence en cuivre, et s'étendent ainsi tout le pourtour du tube enrouleur 3. Un film protecteur isolant électriquement -non représenté sur les figures- de préférence dans un matériau polymère laissant passer le rayonnement solaire, recouvre le panneau photovoltaïque 4, le panneau souple 2 ainsi que les électrodes 15'.

D'autres variantes peuvent être envisagées sans sortir du cadre de la présente invention notamment en ce qui concerne les moyens de raccordement vis-à-vis des pistes conductrices concentriques 26, 27, 26', 27' et des contacteurs électriques 28, 29, 28', 29'. On peut également envisager un nombre différent de panneaux photovoltaïques sur le dispositif de protection solaire de type store.

## Revendications

1. Dispositif de protection solaire du type store (1) muni d'un système de production d'énergie électrique, le dispositif comprenant un panneau souple (2), au moins un panneau photovoltaïque (4) disposé sur la face externe (2d) du panneau souple, un tube enrouleur (3) sur lequel s'enroule le panneau souple et un système de mise en tension du panneau souple durant son déploiement ou son enroulement, **caractérisé en ce que** le bord proximal (2a) du panneau souple (2) est assujetti au tube enrouleur (3) en formant autour dudit tube enrouleur une portion non déroulable, des moyens de liaison électriques (18, 19) étant disposés à l'intérieur (8) du tube enrouleur et traversant ledit tube enrouleur dans la portion non déroulable du panneau souple, lesdits moyens de liaison électriques étant raccordés à l'au moins un panneau photovoltaïque (4) au niveau du bord proximal (2a) du panneau souple (2).

2. Dispositif de protection solaire de type store (1) objet de la revendication 1, lequel comprend un système de transfert électrique (21) comprenant une partie mobile (22) assujettie à l'une (3a) des extrémités du tube enrouleur (3), une partie fixe (23) et des moyens de contact glissant (26, 27, 28, 29, 26', 27', 28', 29') configurés pour transférer l'énergie électrique de la partie mobile (22) vers la partie fixe (23), les moyens de liaison électriques (18, 19) étant raccordés à la partie mobile (22).

3. Dispositif de protection solaire de type store (1) selon la revendication 2, selon lequel la partie mobile (22) du système de transfert électrique (21) comprend deux pistes conductrices concentriques (26, 27) de diamètres différents et la partie fixe (23) du système de transfert électrique comprend au moins deux contacteurs électriques (28, 29) configurés pour être maintenus respectivement en appui contre les deux pistes conductrices concentriques.

4. Dispositif de protection solaire de type store (1) selon la revendication 3, les contacteurs électriques (28, 29) comprenant chacun des premiers moyens de raccordement électrique (36).

5. Dispositif de protection solaire de type store (1) selon la revendication 3, les pistes conductrices concentriques (26, 27) comprenant chacune des seconds moyens de raccordement (34, 35, 32, 33) aux moyens de liaison électriques (18, 19).

6. Dispositif de protection solaire de type store (1) selon la revendication 3, l'au moins un panneau photovoltaïques (4) comprenant au niveau de son bord proximal (40) une électrode positive et une électrode négative, lesdites électrodes (15) positive et négative étant raccordées respectivement aux deux pistes conductrices concentriques (26, 27) par le biais des moyens de liaison électrique (18,19).

7. Dispositif de protection solaire de type store (1) selon la revendication 6, les moyens de liaison électrique sont constitués d'au moins un jeu de deux fils électriques (18, 19) raccordés à leurs premières extrémités (18a, 19a) respectivement aux électrodes (15) positive et négative de l'au moins un panneau photovoltaïque (4) et à leurs secondes extrémités (18b, 19b) respectivement aux deux pistes conductrices concentriques (26, 27).

8. Dispositif de protection solaire de type store (1) selon la revendication 7, les fils électriques (18, 19) ayant leurs premières extrémités (18a, 19a) dénudées, passant au travers du tube enrouleur (3) et soudées aux électrodes (13) du panneau photovoltaïque (4).

9. Dispositif de protection solaire de type store (1) selon la revendication 3, les contacteurs électriques (28, 29) étant montés sur ressort en sorte d'assurer une pression permanente sur les pistes conductrices concentriques (26, 27).

10. Dispositif de protection solaire de type store (1) selon la revendication 1, une liaison (11) du type queue d'aronde étant agencée entre l'extrémité proximale (2b) du panneau souple (2) et le tube enrouleur (3).

11. Dispositif de protection solaire de type store (1) selon la revendication 1, le bord proximal (2a) du panneau souple (2) étant fixé avec le tube enrouleur (3).

12. Dispositif de protection solaire de type store (1) selon la revendication 1, la portion non déroulable du panneau souple (2) s'étend sur au moins un quart de tour du tube enrouleur (3).

13. Dispositif de protection solaire de type store (1) selon la revendication 1, le panneau souple (2) étant recouvert de deux à quatre panneaux photovoltaïques (4).

14. dispositif de protection solaire de type store (1) selon l'une des revendications 2 à 13, **caractérisé en ce qu'**il comprend un moteur (39) d'entraînement en rotation du tube enrouleur (3) et **en ce que** la partie mobile (22) du système de transfert électrique comprend une ouverture centrale (22a) configurée en sorte de recevoir l'extrémité proximale mobile (39b") dudit moteur (39).

15. Dispositif de protection solaire de type store (1) selon l'une des revendications 2 à 14, **caractérisé en ce que** la partie fixe (23) du système de transfert électrique comprend au moins une ouverture (23a, 23b) de sortie des moyens de raccordement électrique du moteur (39) d'entraînement du tube enrouleur (3), et éventuellement un évidement central configuré en sorte de recevoir l'extrémité proximale fixe (39b') dudit moteur (39).

16. Dispositif de protection solaire de type store (1) selon la revendication 1, **caractérisé en ce que** la portion non déroulable (2a, 2a') du panneau souple (2) s'étend sur au moins un quart de tour du tube enrouleur (3), de préférence au moins sur tout le tour du tube enrouleur (3) en sorte de recouvrir le bord proximal (2a) du panneau souple (2) assujetti au tube enrouleur (3) et lesdits moyens de liaison électriques raccordés à l'au moins un panneau photovoltaïques (4) au niveau dudit bord proximal (2a).

17. Dispositif de protection solaire de type store (1) selon la revendication 1, comprenant un moteur (39) d'entraînement du tube enrouleur (3) et un système de commande du moteur configuré pour assurer l'arrêt du moteur lors du déploiement du panneau souple (2) dans une position permettant de conserver en permanence une portion du bord proximal (2a) dudit panneau souple (2) enroulé autour dudit tube enrouleur (3).
